(19) Europäisches Patentamt
European Patent Office
Office européen des brevets

(11) **EP 3 757 480 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**24.06.2026 Patentblatt 2026/26**

(45) Hinweis auf die Patenterteilung:
**23.02.2022 Patentblatt 2022/08**

(21) Anmeldenummer: **20191257.3**

(22) Anmeldetag: **23.02.2018**

(51) Internationale Patentklassifikation (IPC):
*F24S 80/525* $^{(2018.01)}$   *H01L 31/0216* $^{(2014.01)}$
*H01L 31/0236* $^{(2006.01)}$   *H01L 31/048* $^{(2014.01)}$
*G02B 5/28* $^{(2006.01)}$   *G02B 5/02* $^{(2006.01)}$

(52) Gemeinsame Patentklassifikation (CPC):
**F24S 80/525; G02B 5/0221; G02B 5/285;
H10F 19/80; H10F 77/315; H10F 77/707;**
Y02E 10/40; Y02E 10/52; Y02E 10/60

(54) **VERGLASUNGSEINHEIT, VERFAHREN ZU DEREN HERSTELLUNG UND DEREN VERWENDUNG**

GLAZING UNIT, METHOD FOR MANUFACTURING SAME AND USE OF SAME

UNITÉ DE VITRAGE, SON PROCÉDÉ DE FABRICATION ET SON UTILISATION

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **27.02.2017 DE 102017203105**

(43) Veröffentlichungstag der Anmeldung:
**30.12.2020 Patentblatt 2020/53**

(62) Dokumentnummer(n) der früheren Anmeldung(en) nach Art. 76 EPÜ:
**18707348.1 / 3 586 071**

(73) Patentinhaber: **Fraunhofer-Gesellschaft zur Förderung
der angewandten Forschung e.V.
80686 München (DE)**

(72) Erfinder:
• **Höhn, Oliver**
  **79110 Freiburg (DE)**
• **Kroyer, Thomas**
  **79110 Freiburg (DE)**
• **Bläsi, Benedikt**
  **79110 Freiburg (DE)**
• **Kuhn, Tilmann**
  **79110 Freiburg (DE)**
• **Hinsch, Andreas**
  **79110 Freiburg (DE)**

(74) Vertreter: **Friese Goeden Patentanwälte
PartGmbB
Widenmayerstraße 49
80538 München (DE)**

(56) Entgegenhaltungen:
WO-A1-2004/079278   WO-A1-2014/045144
WO-A1-2015/155357   DE-A1- 102013 205 671
US-A1- 2005 150 864   US-A1- 2008 316 594
US-A1- 2009 153 953   US-A1- 2010 208 338
US-A1- 2011 134 515

• **WEI ZHANG ET AL: "Highly Efficient Perovskite Solar Cells with Tunable Structural Color", NANO LETTERS, vol. 15, no. 3, 11 March 2015 (2015-03-11), pages 1698 - 1702, XP055201121, ISSN: 1530-6984, DOI: 10.1021/nl504349z**
• **VON FREYMANN G ET AL: "Three-Dimensional Nanostructures for Photonics", ADVANCED FUNCTIONAL MATERIALS, WILEY - V C H VERLAG GMBH & CO. KGAA, DE, vol. 20, no. 7, 9 April 2010 (2010-04-09), pages 1038 - 1052, XP001554262, ISSN: 1616-301X, [retrieved on 20100318], DOI: 10.1002/ADFM.200901838**

EP 3 757 480 B2

**Beschreibung**

Die Erfindung betrifft eine Verglasungseinheit, die mindestens ein Polymer aufweist, sowie ein Verfahren zu deren Herstellung und deren Verwendung. Verglasungseinheiten der eingangs genannten Art können beispielsweise als Fassadenelement verwendet werden.

Der Markt für bauwerkintegrierte Photovoltaik (BIPV) und die gebäudeintegrierte Solarthermie weist national und weltweit sehr große Potentiale auf. Die bisher nur sehr eingeschränkten Gestaltungsmöglichkeiten sind ein Hindernisgrund für die breite Akzeptanz und Anwendung von solchen Technologien an Bauwerken. Um die Akzeptanz und Attraktivität zu erhöhen, werden zunehmend Solarmodule mit photovoltaischen Zellen und thermische Solarkollektoren angefragt, bei denen deren Funktion mit Hilfe von Farbeffekten maskiert werden können und welche somit nicht mehr wahrnehmbar sind. Besonders gewünscht ist die Möglichkeit, die Farbe gezielt und individuell (z.B. Strukturierung mit dem eigenen Firmenlogo) beeinflussen zu können und gleichzeitig einen möglichst hohen Wirkungsgrad zu erhalten. Dabei soll der Farbeindruck der Module vom Betrachtungswinkel möglichst unabhängig sein und Blendeffekte sollen je nach Einsatzort vermieden werden. Bisherige Konzepte weisen entweder einen nicht tolerierbaren Effizienzverlust auf, sind in der Farbwahl eingeschränkt oder industriell nicht umsetzbar.

Wenn man beispielsweise BIPV-Module optisch ansprechender gestalten will, dann gibt es grundsätzlich zwei unterschiedliche Optionen. Man kann versuchen, das Modul so zu gestalten, dass die Zellen nicht wahrnehmbar sind, indem vor die Zellen eine zum Beispiel farbige oder streuende Glasscheibe eingesetzt wird. Bei dieser Option sind die Solarmodule nicht mehr sichtbar. Dabei ist es wichtig, die durch die Glasscheibe bislang unvermeidliche Effizienzminderung zu minimieren, damit ein hinreichender Effekt auf die Energiebilanz des Gebäudes realisiert werden kann.

Alternativ dazu kann versucht werden, die Zellen sichtbar zu lassen und bewusst als Gestaltungselement einzusetzen, indem eine spezielle Form, Größe oder Position der Solarzellen gewählt wird.

Im Falle der ersten Option kann als farbige Glasscheibe das eingefärbte Moduldeckglas verwendet werden. Eine Möglichkeit ist die Einfärbung bzw. das Bedrucken des Glases mit absorbierenden Farbpigmenten. Dadurch ist zwar eine relativ freie und einfache Farbwahl möglich, aber aufgrund der Absorption eines Teilbereiches des elektromagnetischen Spektrums durch die Farbpigmente entstehen hohe Verluste, wenn eine echte unsichtbare Photovoltaik erreicht werden soll. Dadurch ist eine weite Akzeptanz praktisch ausgeschlossen. Auch lumineszente Materialien können eingesetzt werden, wobei hier der Gesamtwirkungsgrad gut bleibt. Allerdings ist auch bei der Verwendung lumineszenter Materialien eine industrielle Umsetzung noch weit entfernt und die Farbwahl hängt von der Farbe der verfügbaren lumineszenten Materialien ab und ist daher eingeschränkt.

Durch den Einsatz einer selektiv reflektierenden Deckschicht wird der Gesamtwirkungsgrad nur minimal beeinflusst und es erschließen sich weitere Gestaltungsspielräume. Nachteilig ist die Winkelabhängigkeit des Farbeindruckes, was bei Gebäuden in der Regel unerwünscht ist.

Eine Verglasungseinheit mit einer Beschichtung, welche das Problem der Winkelabhängigkeit mindert, ist aus der US 2015/0249424 A1 bekannt. Diese Beschichtung besteht aus einem komplexen Schichtaufbau und führt zu einem Reflexionsverlust von 8 % - 12 %. Ein entsprechendes Produkt (Kromatix™) ist in sechs verschiedenen Farben erhältlich. Allerdings weist diese Technologie erhebliche Nachteile auf. Der winkelunabhängige Farbeindruck beruht auf einem sehr speziellen, komplexen Dünnschichtfilter, was die Zahl der möglichen Farben und Freiheitsgrade sowie die erreichbare Farbsättigung einschränkt.

Eine Verglasungseinheit nach dem Oberbegriff des Anspruchs 1 ist aus der WO2015155357 bekannt.

Ausgehend von diesem Stand der Technik liegt der Erfindung somit die Aufgabe zugrunde, eine Verglasungseinheit mit verbesserten Eigenschaften bereitzustellen.

Die Aufgabe wird erfindungsgemäß durch eine Verglasungseinheit gemäß Anspruch 1, ein Verfahren zur Herstellung dieser Verglasungseinheit nach Anspruch 10, ein Solarmodul, das die Verglasungseinheit aufweist nach Anspruch 14 und einen thermischen Solarkollektor nach Anspruch 15 gelöst. Vorteilhafte Weiterbildungen der Erfindung finden sich in den Unteransprüchen.

Erfindungsgemäß wird eine Verglasungseinheit zur ästhetischen Gestaltung beispielsweise von Fassadenflächen und Dachflächen vorgeschlagen, die mindestens eine photonische Struktur und ein Polymer umfasst oder daraus besteht, wobei das Polymer eine erste strukturierte Oberfläche aufweist, auf die die photonische Struktur aufgebracht ist.

Die erfindungsgemäße Verglasungseinheit enthält zumindest ein transparentes oder transluzentes Material als Substrat, welches nachfolgend als "Glas" bezeichnet wird. Ungeachtet der Bezeichnung als "Glas" besteht das transparente oder transluzente Material aus zumindest einem Polymer, auf welchem nachfolgend die beschriebene strukturierte Oberfläche und die photonische Struktur aufgebracht wird.

Photonische Strukturen im Sinne der vorliegenden Beschreibung sind in transparenten oder transluzenten Festkörpern vorkommende oder geschaffene Modulationen des Brechungsindex. Die photonische Struktur enthält somit zumindest erste Raumbereiche mit einem ersten Brechungsindex und zweite Raumbereiche mit einem zweiten Brechungsindex, so dass durch Beugung, Reflexion an Grenzflächen und/oder Interferenz die Propagation von Licht beeinflusst wird. Hierzu wird der Brechungsindex in mindestens einer Raumrichtung in Dimensionen moduliert, welche in der gleichen Größenordnung wie die Wellenlänge des relevanten Lichts liegen.

Die ersten und zweiten Raumbereiche können in einigen Ausführungsformen der Erfindung in Form einer Mehrzahl von Dünnschichten unterschiedlicher Zusammensetzung oder zwei verschiedener Zusammensetzungen und optional unterschiedlicher Dicke ausgeführt sein. In einigen Ausführungsformen kann die optische Schichtdicke der einzelnen Schichten etwa einem Viertel der Designwellenlänge entsprechen, bei welcher das Haupt-Reflexionsmaximum (0. Harmonische) erscheint.

Die erfindungsgemäß verwendeten photonische Strukturen sind dazu eingerichtet, ein erstes Teilspektrum eintreffender elektromagnetischer Strahlung zu reflektieren und ein zweites Teilspektrum eintreffender elektromagnetischer Strahlung zu transmittieren, wobei der reflektierte Anteil einer höheren Harmonischen entspricht und im sichtbaren Spektralbereich liegt. Eine höhere Harmonische weist dabei eine geringere Wellenlänge bzw. eine geringere mittlere Wellenlänge einer Wellenlängenverteilung auf als das Haupt-Reflexionsmaximum (0. Harmonische). In einigen Ausführungsformen der Erfindung kann die 2. oder 3. Harmonische verwendet werden. In dispersionsfreien Medien treten die höheren Harmonischen bei ganzzahligen Vielfachen der Frequenz des Haupt-Reflexionsmaximums (0. Harmonische) auf.

Erfindungsgemäß wurde erkannt, dass die Verwendung einer höheren Harmonischen eines Dünnschichtfilters im sichtbaren Spektralbereich eine höhere Farbsättigung und eine Vielzahl von möglichen Farben und Gestaltungsmöglichkeiten bietet. Durch die erfindungsgemäße Kombination der photonischen Struktur mit der strukturierten Oberfläche kann die Winkelabhängigkeit des Farbeindruckes reduziert oder aufgehoben werden. Ein mit der erfindungsgemäßen Verglasungseinheit versehenes Gebäude weist aus vielen oder allen Betrachtungswinkeln den identischen Farbeindruck auf.

Die ersten und zweiten Raumbereiche der photonischen Struktur können nicht-periodisch angeordnet sein.

Die ersten und zweiten Raumbereiche können periodisch angeordnet sein. Hierzu können Schichten gleicher Dicke und Zusammensetzung Verwendung finden. Die photonische Struktur kann beispielsweise durch Interferrenzeffekte Licht einer vorgebbaren Wellenlänge oder eines Wellenlängenbereiches reflektieren und andere Wellenlängen transmittieren. Die Reflektionswellenlänge oder der Maximalwert des Wellenlängenbereiches wird nachfolgend auch als Bragg-Wellenlänge bezeichnet. Die Breite des reflektierten Wellenlängenbereiches unter senkrechtem Einfall kann weniger als 75nm, weniger als 65nm oder weniger als 60nm betragen.

Erfindungsgemäß befindet sich eine solche photonische Struktur auf einer strukturierten Oberfläche des Glases. Das Glas weist dazu zumindest eine erste strukturierte Oberfläche auf, auf welche die photonische Struktur aufgebracht ist. Diese wird daher nachfolgend auch als dreidimensionale photonische Struktur bezeichnet. Die erste strukturierte Oberfläche kann eine Teilfläche einer Seite des Glases umfassen oder eine vollständige Seite des Glases kann mit der strukturierten Oberfläche versehen sein. Eine strukturierte Oberfläche im Sinne der vorliegenden Erfindung bezeichnet eine Struktur, welche Erhebungen und Vertiefungen aufweist. In einigen Ausführungsformen der Erfindung kann RMS-Rauheit zwischen etwa 30 nm und etwa 100 $\mu$m oder zwischen etwa 80 nm und etwa 10 $\mu$m liegen. Die strukturierte Oberfläche kann periodisch oder aperiodisch strukturiert sein.

Erfindungsgemäß wird in einigen Ausführungsformen ein Dünnschichtfilter als photonische Struktur auf eine strukturierte Oberfläche aufgebracht. Dieser Dünnschichtfilter ist damit ebenfalls strukturiert, sodass dieser nicht wie sonst üblich als planer Dünnschichtfilter betrachtet werden kann. Der Dünnschichtfilter kann dennoch als Bragg-Filter oder als ähnlicher Filter designt werden. Erfindungsgemäß wurde jedoch erkannt, dass sich einige Eigenschaften der als Dünnschichtfilter designten Struktur durch das Aufbringen auf ein strukturiertes Glas wesentlich ändern, sodass nicht mehr von einem eindimensionalen Dünnschichtfilter gesprochen werden kann. Erhalten bleiben bei dieser Realisierungsform die Hauptreflexionsmaxima, aber auch höhere Harmonische der Dünnschichtstruktur, wobei deren genaue Lage durch die durch die Schichtfolge der Einzelschichten des Dünnschichtfilters beeinflusst werden kann. Einer der wesentlichen Einflüsse der strukturierten Oberfläche ist der Einfluss auf die Winkelabhängigkeit der Reflexionspeaks. Ein planes Dünnschichtfilter auf einer strukturierten Oberfläche wird daher im Sinne der vorliegenden Beschreibung auch als dreidimensionale photonische Struktur bezeichnet.

In einigen Ausführungsformen kann der mittlere Brechungsindex der Verglasungseinheit größer als etwa 1,6 oder größer als etwa 1,8 oder größer als etwa 1,95 sein, jeweils bestimmt bei einer Wellenlänge von 550 nm. Der mittlere Brechungsindex ist definiert als mit der mit den Volumenanteilen des jeweiligen Materials gewichteten Mittelung des Brechungsindex. Dieser kann durch folgende Verfahrensschritte bestimmt werden:

Bestimmung der Gesamtdicke aller Schichten $D_{ges}$ des Dünnschichtfilters der photonischen Struktur, beispielsweise durch Lichtmikroskopie oder Rasterelektronenmikroskopie,
Bestimmung der Anzahl unterschiedlicher Schichten des Dünnschichtfilters, beispielsweise mit EDX,
damit Bestimmung der Anzahl der Symmetrielemente $N_{sym}$ des Dünnschichtfilters,
Bestimmung der Wellenlänge des Hauptpeaks $LD_{HP}$,
Bestimmung der Wellenlänge der m. Harmonischen $LD_m$,
Bestimmung von m über Division der Peakwellenlängen:

m = LD$_{HP}$/LD$_m$-1 und Runden auf eine ganze Zahl,
Berechnen des mittleren Brechungsindex n nach folgender

$$\text{Formel: } n = N_{sym}/D_{ges} \times 0.5 \times LD_m \times (m+1)$$

Erfindungsgemäß wird zumindest eine erste Seite des Glases mit der erfindungsgemäßen photonischen Struktur versehen, welche auf einer strukturierten Oberfläche angeordnet ist. Diese erste Seite kann in einigen Ausführungsformen die von der Witterung abgewandte Innenseite sein, so dass die photonischen Struktur vor Bewitterung und Verschmutzung geschützt ist. In anderen Ausführungsformen der Erfindung kann die erste Seite des Glases mit der erfindungsgemäßen photonischen Struktur die bei Betrieb bzw. nach Endmontage außenliegende Oberfläche sein. Hierdurch kann die Farbsättigung erhöht sein.

Die photonische Struktur weist eine höhere Harmonische im sichtbaren Spektralbereich auf. Dies kann dadurch erfolgen, dass die Schichtdicken der photonische Struktur vergrößert werden. Dieses Merkmal hat die Wirkung, dass die spektrale Breite des reflektierten Wellenlängenbereiches kleiner wird. Eine höhere Harmonische zeichnet sich dadurch aus, dass die reflektierte Wellenlänge bzw. der Mittelwert eines Wellenlängenbereichs geringer ist als die reflektierte Wellenlänge bzw. der Mittelwert eines Wellenlängenbereichs der 0. Harmonischen bzw. der Hauptwellenlänge. In einigen Ausführungsformen der Erfindung handelt es sich bei der höhere Harmonischen um die 2. oder 3. Harmonische. Hierdurch kann die Farbsättigung in Reflektion und die Transmission erhöht sein. Somit steht ein größerer Anteil des Lichtspektrums zur Nutzung durch Photovoltaik oder thermische Kollektoren zur Verfügung und gleichzeitig nimmt ein Betrachter statt einzelner Zellen eine homogen gefärbte Fläche war.

In einigen Ausführungsformen der Erfindung können die Reflexionsverluste der Verglasungseinheit weniger als 12 % oder weniger als 9 % betragen.

Durch das Aufbringen der erfindungsgemäßen dreidimensionalen photonischen Struktur auf ein Modulglas eines Photovoltaikmoduls kann die erfindungsgemäße Verglasungseinheit als Teil eines Photovoltaikmoduls eingesetzt werden. Der Herstellungsprozess des Photovoltaikmoduls kann dabei nahezu unverändert bleiben. Gleichwohl ist die Farbgestaltung frei wählbar, so dass die erfindungsgemäßen Photovoltaikmodule einen breiteren Einsatzbereich aufweisen können. Die Photovoltaikmodule können an Flächen eingesetzt werden, an welchen sich der Einsatz konventioneller Photovoltaikmodule bislang aus gestalterischen Gründen verboten hat. In gleicher Weise können auch thermische Solarkollektoren mit der erfindungsgemäßen Verglasungseinheit ausgestattet werden. Weiterhin können Verglasungseinheiten mit der selektiven Schicht direkt ohne Lamination z.B. in nichtlaminierten Photovoltaikmodulen verwendet werden.

In einigen Ausführungsformen der Erfindung kann die photonische Struktur erste Schichten aufweisen, welche ein erstes Material enthalten, welches einen ersten Brechungsindex aufweist und die photonische Struktur kann zweite Schichten aufweist, welche ein zweites Material enthalten, welches einen zweiten Brechungsindex aufweist, wobei der erste Brechungsindex zwischen etwa 1,5 und etwa 2,2 beträgt und der zweite Brechungsindex zwischen etwa 1,8 und etwa 2,5 beträgt. Der Brechungsindexkontrast kann in einigen Ausführungsformen der Erfindung zwischen etwa 0,2 und etwa 0,9 betragen. Hierdurch wird die Farbsättigung erhöht und die Reflexionsverluste können weiter reduziert sein.

In einigen Ausführungsformen der Erfindung weist die dreidimensionale photonische Struktur einen Dünnschichtfilter auf oder besteht daraus, wobei der Dünnschichtfilter ein periodischer Dünnschichtfilter, insbesondere ein Bragg-Filter sein kann. Dabei kann der Bragg-Filter abwechselnd Schichten aus einem ersten Material und einem zweiten Material aufweisen oder daraus bestehen. Das erste und/oder das zweite Material kann $ZrO_2$ und/oder $Nb_2O_5$ und/oder $TiO_2$ und/oder $Si_3N_4$ und/oder $SiO_2$ und/oder AlN, $SnO_2$ und/oder $Al_2O_3$ und/oder $HfO_2$ und/oder $Ta_2O_5$ und/oder $SiO_xN_y$ und/oder $AlO_xN_y$ und/oder ZnO und/oder $Bi_2O_3$ und/oder $In_2O_3$ und/oder $WO_3$ und/oder $MoO_3$ enthalten oder daraus bestehen. In einigen Ausführungsformen der Erfindung kann das erste und/oder das zweite Material zusätzlich einen Dotierstoff enthalten.

Ausführungsbeispiele für Bragg-Filter sind die folgenden Schichtaufbauten a) bis c):

a) $Si_3N_4$ insbesondere in einer Dicke von 140 nm, $TiO_2$ insbesondere in einer Dicke von 170 nm, $Si_3N_4$ insbesondere in einer Dicke von 200 nm, $TiO_2$ insbesondere in einer Dicke von 170 nm und $Si_3N_4$ insbesondere in einer Dicke von 140 nm, oder

b) $Si_3N_4$ insbesondere in einer Dicke von 165 nm, $TiO_2$ insbesondere in einer Dicke von 190 nm, $Si_3N_4$ insbesondere in einer Dicke von 240 nm, $TiO_2$ insbesondere in einer Dicke von 190 nm und $Si_3N_4$ insbesondere in einer Dicke von 165 nm, oder

c) $Si_3N_4$ insbesondere in einer Dicke von 120 nm, $TiO_2$ insbesondere in einer Dicke von 140 nm, $Si_3N_4$ insbesondere in einer Dicke von 170 nm, $TiO_2$ insbesondere in einer Dicke von 140 nm und $Si_3N_4$ insbesondere in einer Dicke von 120 nm.

Um einen Oxidation der $Si_3N_4$-Schichten zu vermeiden, wenn diese eine äußere Schicht der photonischen Struktur bildet, kann darauf eine Passivierungsschicht angeordnet werden. Die Passivierungsschicht kann $SiO_2$ enthalten oder daraus bestehen und beispielsweise eine Dicke von etwa 120 nm bis etwa 210 nm aufweisen.

Beispiele von photonischen Strukturen und dem sich ergebenden Farbeindruck der Verglasungseinheiten sind in der folgenden Tabelle angegeben:

| grün | Strukturiertes Glas/$Si_3N_4$ 140 nm/$TiO_2$ 170 nm/$Si_3N_4$ 200 nm/$TiO_2$ 170 nm/$Si_3N_4$ 140 nm/$SiO_2$ 140 nm |
|---|---|
| rot | Strukturiertes Glas/$Si_3N_4$ 165 nm/$TiO_2$ 190 nm/$Si_3N_4$ 240 nm/$TiO_2$ 190 nm/$Si_3N_4$ 165 nm/$SiO_2$ 210 nm |
| blau | Strukturiertes Glas/$Si_3N_4$ 120 nm/$TiO_2$ 140 nm/$Si_3N_4$ 170 nm/$TiO_2$ 140 nm/$Si_3N_4$ 120 nm/$SiO_2$ 120 nm |
| grün alternativ | Strukturiertes Glas/$Si_3N_4$ 140 nm/$TiO_2$ 170 nm/$Si_3N_4$ 140 nm/$SiO_2$ 140 nm |
| rot alternativ | Strukturiertes Glas/$Si_3N_4$ 165 nm/$TiO_2$ 190 nm/$Si_3N_4$ 165 nm/$SiO_2$ 210 nm |
| blau alternativ | Strukturiertes Glas/$Si_3N_4$ 120 nm/$TiO_2$ 140 nm/$Si_3N_4$ 120 nm/$SiO_2$ 120 nm |

In einigen Ausführungsformen kann die optionale Deckschicht, welche $SiO_2$ enthält oder daraus besteht, auch entfallen. Zum Schutz vor Umwelteinflüssen können solche Verglasungseinheiten ohne abschließende $SiO_2$-Schicht in zumindest einer Polymerfolie laminiert werden. Sofern eine solche Lamination entfällt, kann die abschließende $SiO_2$-Schicht mit einer Dicke zwischen etwa 100 nm und etwa 230 nm die Gesamtreflexion vermindern und/oder die Degeneration durch Umwelteinflüsse reduzieren. Sofern vorgesehen ist, die Verglasungseinheit zu laminieren, kann eine abschließende $SiO_2$-Schicht die Verbindung zur Laminierfolie verbessern. Hierzu kann die abschließende $SiO_2$-Schicht auch dünner gewählt sein und beispielsweise eine Dicke zwischen etwa 5 nm und etwa 50 nm oder zwischen etwa 3 nm und etwa 100 nm aufweisen.

Dabei bedeutet der Ausdruck "strukturiertes Glas" ein Glas, das eine erste strukturierte Oberfläche aufweist, auf das Dünnschichtfilter als dreidimensionale photonische Struktur aufgebracht ist.

In einigen Ausführungsformen weist die Verglasungseinheit mehrere dreidimensionale photonische Strukturen auf, welche jeweils unterschiedliche Wellenlängenbereiche reflektieren. In einigen Ausführungsformen der Erfindung können 2 oder 3 dreidimensionale Strukturen verwendet werden, welche unterschiedliche Farben ergeben, z.B. rot, grün und blau. Dadurch ist es möglich, durch additive Farbmischung einen breiten Farbraum aufzuspannen.

Ein solcher breiter Farbraum kann auch erreicht werden, indem eine einzige dreidimensionale photonische Struktur mit mehreren Reflexionspeaks mit voneinander verschiedenen Wellenlängen bzw. Wellenlängenbereichen verwendet wird. Dies kann in einigen Ausführungsformen der Erfindung durch nichtperiodische Strukturen oder durch periodische Strukturen mit mehreren verschiedenen Schichtdicken erreicht werden.

In einigen Ausführungsformen kann das in der Verglasungseinheit vorliegende Glas eine zweite strukturierte Oberfläche aufweisen, die sich gegenüber der ersten strukturierten Oberfläche befindet. Die zweite strukturierte Oberfläche kann beispielsweise als Entspiegelungsschicht dienen. In dieser Ausführung ist durch die entfallende Reflexion der Vorderseite eine noch höhere Farbsättigung erreichbar.

In einigen Ausführungsformen kann die Verglasungseinheit erste Teilflächen aufweisen, welche eine erste photonische Struktur aufweisen und zweite Teilflächen aufweisen, welche eine zweite photonische Struktur oder keine photonische Struktur aufweisen. Wenn Teilflächen der Verglasungseinheit keine photonische Struktur aufweisen, erscheinen diese schwarz. Wenn Teilflächen der Verglasungseinheit eine andere photonische Struktur aufweisen als andere Teilflächen, so können diese in einer anderen Farbe erscheinen, wenn sich die Schichtdicken oder das Material der Einzelschichten unterscheiden. In anderen Ausführungsformen der Erfindung können Teilflächen mit dem identischen Bragg-Filter versehen sein, aber eine geringere Rauheit bzw. eine andere Oberflächenstrukturierung aufweisen. Hierdurch kann sich eine Winkelabhängigkeit des Farbeindruckes einstellen. Durch die Aufteilung in erste und zweite Teilflächen können Muster, Logos oder andere gestalterische Elemente auf der Verglasungseinheit ausgeführt werden.

Erfindungsgemäß wird weiter ein Verfahren zur Herstellung einer erfindungsgemäßen Verglasungseinheit bereitgestellt. Dabei wird zuerst die erste strukturierte Oberfläche auf dem Glas hergestellt und dann auf diese erste strukturierte Oberfläche die dreidimensionale photonische Struktur aufgebracht.

In einigen Ausführungsformen kann das Aufbringen der dreidimensionalen photonischen Struktur auf der ersten strukturierten Oberfläche des Glases durch Sputtern erfolgen. Dabei handelt es sich um einen weit verbreiteten Prozess zur Beschichtung von Architekturglas, so dass die erfindungsgemäße Verglasungseinheit einfach mit bestehenden Anlagen hergestellt werden kann. Bei diesem Verfahren können somit übliche Abdeckgläser für Solarmodule und thermische Solarkollektoren verwendet werden, die dann in üblicher Weise zur weiteren Herstellung der Solarmodule bzw. thermischen Solarkollektoren verwendet werden können.

In einigen Ausführungsformen kann die Herstellung der ersten strukturierten Oberfläche des Glases durch Sandstrahlen, Prägen, Ätzen, Gießen oder Walzen erfolgen. Wie bereits vorstehend ausgeführt wurde, kann in einigen Ausführungsformen die Verglasungseinheit eine zweite strukturierte Oberfläche aufweisen. Auch diese kann durch Sandstrahlen, Prägen, Ätzen, Gießen oder Walzen hergestellt werden. Sofern eine Unterteilung in erste und zweite Teilflächen mit unterschiedlicher Rauheit erwünscht ist, kann eine optionale Maskierung erfolgen. Die Maske kann insbesondere durch ein Druckverfahren aufgebracht werden.

Wenn die Verglasungseinheit erste Teilflächen aufweist, welche eine erste photonische Struktur aufweisen und zweite Teilflächen aufweist, welche eine zweite photonische Struktur oder keine photonische Struktur aufweisen, kann auch vor der Erzeugung der photonischen Struktur eine Maske aufgebracht werden. Dies kann in einigen Ausführungsformen der Erfindung durch ein Druckverfahren erfolgen. Sofern die Maske aus organischem Material besteht, kann diese durch Veraschen entfernt werden. In einigen Ausführungsformen der Erfindung kann das Veraschen zeitgleich mit einer Wärmebehandlung zum Härten der Verglasungseinheit erfolgen.

Ferner wird erfindungsgemäß ein Solarmodul bereitgestellt, das eine erfindungsgemäße Verglasungseinheit, insbesondere wie sie vorstehend beschrieben wurde, aufweist. Dabei kann die erfindungsgemäße Verglasungseinheit in an sich bekannten Solarmodulen vorhanden sein. Insbesondere kann das Solarmodul die Verglasungseinheit, einen ersten Einbettungsfilm, eine Solarzelle, einen zweiten Einbettungsfilm und eine Rückseitenfolie aufweisen. Beispiele für die Materialien des Einbettungsfilms sind Ethylenvinylacetat und/oder Silikon.

In einigen Ausführungsformen kann die Verglasungseinheit auf einen an sich bekannten thermischen Solarkollektor aufgebracht sein.

Die erfindungsgemäße Verglasungseinheit kann zur ästhetischen Gestaltung einer Vielzahl unterschiedlichster Flächen und Oberflächen verwendet werden. Dabei ist es möglich, dass ein Teil der Fläche/Oberfläche mit der erfindungsgemäßen Verglasungseinheit verglast ist und andere Teile der Fläche/Oberfläche in üblicher Weise gestaltet sind.

Die erfindungsgemäße Verglasungseinheit kann als Abdeckglas für bauwerksintegrierte Photovoltaik (BIPV), gebäudeintegrierte Solarthermie, Aufdachanlagen mit besonderer farblicher Gestaltung, als normale nichtsolare Verglasung beispielsweise im Brüstungsbereich von vollverglasten Gebäuden oder als farbige Fahrzeugverglasung. Im letzten Fall kann ein Schriftzug, ein Muster oder ein Logo eingebracht werden und durch den Schriftzug trotzdem noch Licht durch die Verglasung in den dahinterliegenden Raum gelangen.

Nachfolgend soll die Erfindung anhand von Figuren und Ausführungsbeispielen ohne Beschränkung des allgemeinen Erfindungsgedankens näher erläutert werden. Dabei zeigt:

Fig. 1          eine erfindungsgemäße Verglasungseinheit in einer ersten Ausführungsform.

Fig. 2          zeigt eine zweite Ausführungsform der erfindungsgemäßen Verglasungseinheit.

Fig. 3          zeigt eine dritte Ausführungsform der erfindungsgemäßen Verglasungseinheit.

Fig. 4          zeigt eine vierte Ausführungsform der erfindungsgemäßen Verglasungseinheit.

Fig. 5a und b          zeigen eine fünfte Ausführungsform der erfindungsgemäßen Verglasungseinheit.

Fig. 6          zeigt eine sechste Ausführungsform der erfindungsgemäßen Verglasungseinheit.

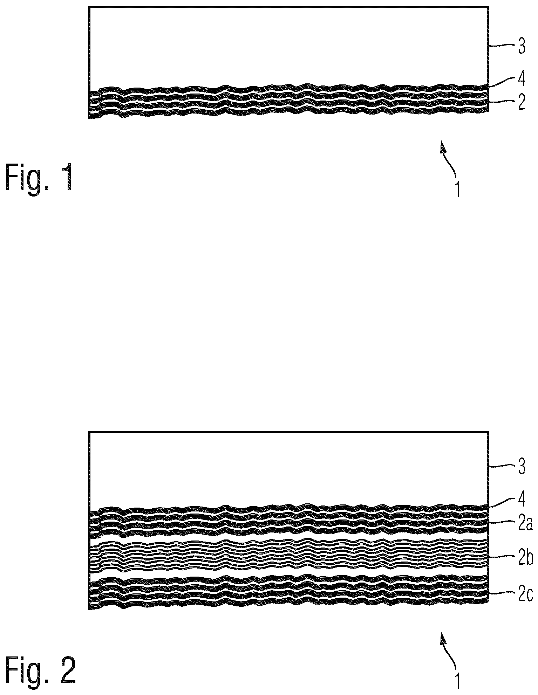

Fig. 1 zeigt eine erste Ausführungsform der erfindungsgemäßen Verglasungseinheit 1. Dabei ist in Fig. 1 eine dreidimensionale photonische Struktur 2 und ein Glas 3 dargestellt, wobei das Glas 3 eine erste strukturierte Oberfläche 4 aufweist, auf die die dreidimensionale photonische Struktur 2 aufgebracht ist.

Das Glas 3 stellt ein Trägermaterial für die dreidimensionale photonische Struktur dar. Das Glas 3 ist ein transparentes oder transluzentes Material, welches auch aus mehreren, nicht dargestellten Schichten aus unterschiedlichen Materialien zusammengesetzt sein kann. Beispielsweise kann das Glas 3 mit einer Vergütungsschicht versehen sein oder als Verbundsicherheitsglas zumindest eine Polymerfolie enthalten, welche vollflächig mit benachbarten Glasschichten verbunden ist. Das Substrat besteht ungeachtet der Bezeichnung als "Glas" vollständig aus zumindest einem Polymer, auf welchem nachfolgend die beschriebene strukturierte Oberfläche und die photonische Struktur aufgebracht wird.

Die dreidimensionale photonische Struktur 2 ist in dieser ersten Ausführungsform als Dünnschichtfilter aus mehreren alternierenden Einzelschichten aufgebaut, welche jeweils $Si_3N_4$ oder $TiO_2$ enthalten. Durch die Wahl der Schichtabstände kann die Reflexionswellenlänge und damit die Farbgestaltung der Verglasungseinheit 1 gewählt werden, so dass sie eine bestimmte Farbe, beispielsweise rot, zeigt. Die Schichtabstände können zwischen etwa 100 nm und etwa 250 nm gewählt werden. Die Zahl der Einzelschichten kann zwischen 1 und etwa 100 oder zwischen etwa 3 und etwa 20 betragen.

Die Einzelschichten der photonische Struktur 2 sind auf einer strukturierten Oberfläche 4 aufgebracht, welche durch Sandstrahlen, Walzen, Ätzen, Gießen oder Prägen in an sich bekannter Weise hergestellt werden kann.

Da das Glas 3 eine strukturierte Oberfläche 4 aufweist, ist das Dünnschichtfilter damit ebenfalls strukturiert, sodass dieses nicht wie sonst üblich als planer Dünnschichtfilter betrachtet werden kann. Das Dünnschichtfilter kann dennoch als Bragg-Filter oder als ähnliches Filter designt werden. Erfindungsgemäß wurde jedoch erkannt, dass sich einige Eigenschaften der als Dünnschichtfilter designten Struktur durch das Aufbringen auf ein strukturiertes Glas 3 wesentlich ändern, sodass nicht mehr von einem eindimensionalen Dünnschichtfilter gesprochen werden kann. Erhalten bleiben bei dieser Realisierungsform die Hauptreflexionsmaxima, aber auch höhere Harmonische der Dünnschichtstruktur, wobei deren genaue Lage durch die Schichtfolge der Einzelschichten des Dünnschichtfilters beeinflusst werden kann. Einer der wesentlichen Einflüsse der strukturierten Oberfläche ist ein Einfluss auf die Winkelabhängigkeit der Reflexionspeaks. Die Farbgestaltung der Verglasungseinheit 1 weist bei Änderung des Betrachtungswinkels eine geringere Variation auf als bekannte, farbige Verglasungseinheiten. Gleichzeitig ist die Transmission für das für die solare Energieerzeugung verwendbare Spektrum größer als bei bekannten, insbesondere pigmentierten farbigen Verglasungseinheiten.

In Fig. 2 wird eine zweite Ausführungsform der erfindungsgemäßen Verglasungseinheit 1 gezeigt, bei der auf der strukturierten Oberfläche 4 des Glases 3 drei unterschiedliche dreidimensionale photonische Strukturen 2a, 2b, 2c erzeugt worden sind. Diese unterscheiden sich darin, dass sie unterschiedliche Farben zeigen, d.h. Licht bei jeweils unterschiedlichen Wellenlängen reflektieren. Auf diese Weise ist es möglich, durch Überlagung von drei Grundfarben auch Mischfarben zu erzeugen und damit die Gestaltungsmöglichkeiten weiter zu erhöhen.

Die unterschiedlichen dreidimensionalen photonischen Strukturen 2a, 2b und 2c können durch hintereinander erfolgendes Sputtern auf die zuvor strukturierte Oberfläche 4 des Glases 3 aufgebracht werden. Die photonischen Strukturen 2a, 2b und 2c können sich durch die Zusammensetzung und/oder die Dicke und/oder die Anzahl der Einzelschichten unterscheiden.

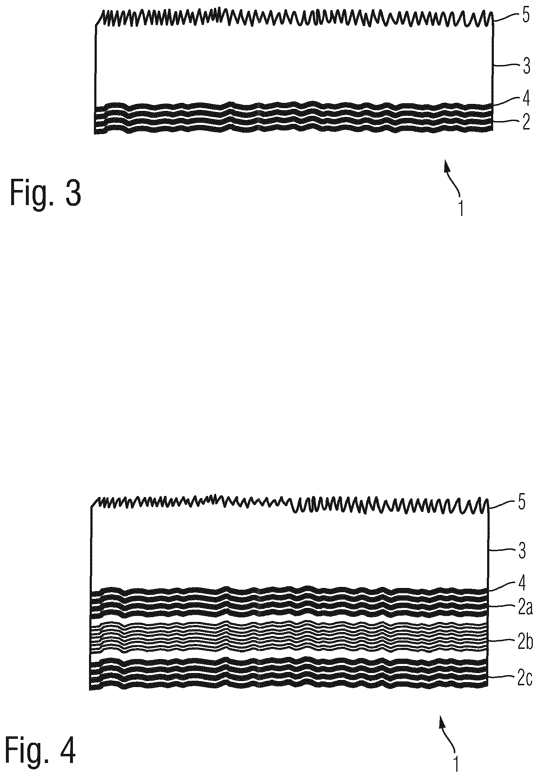

Die dritte Ausführungsform der erfindungsgemäßen Verglasungseinheit 1 nach Fig. 3 zeigt, dass das Glas 3 eine zweite strukturierte Oberfläche 5 aufweist, die sich gegenüber der ersten strukturierten Oberfläche 4 des Glases 3 befindet.

Die zweite strukturierte Oberfläche 5 kann dazu dienen, unerwünschte Spiegelungen an der Oberfläche zu vermeiden, welche Passanten blenden könnten und die durch die Verglasungseinheit hindurchtretende Intensität weiter reduzuieren können.

Die vierte Ausführungsform der erfindungsgemäßen Verglasungseinheit 1 weist ebenfalls eine zweite strukturierte Oberfläche 5, ein Glas 3 und eine erste strukturierte Oberfläche 4 auf. Insofern entspricht sie der in der Fig. 3 dargestellten dritten Ausführungsform der erfindungsgemäßen Verglasungseinheit. Die Verglasungseinheit 1 gemäß der Fig. 4 weist aber, ähnlich wie Fig. 2, drei unterschiedliche dreidimensionalen photonische Strukturen 2a, 2b und 2c auf, die einen unterschiedlichen farblichen Eindruck hervorrufen, so dass insgesamt der Gesamteindruck einer Mischfarbe entsteht.

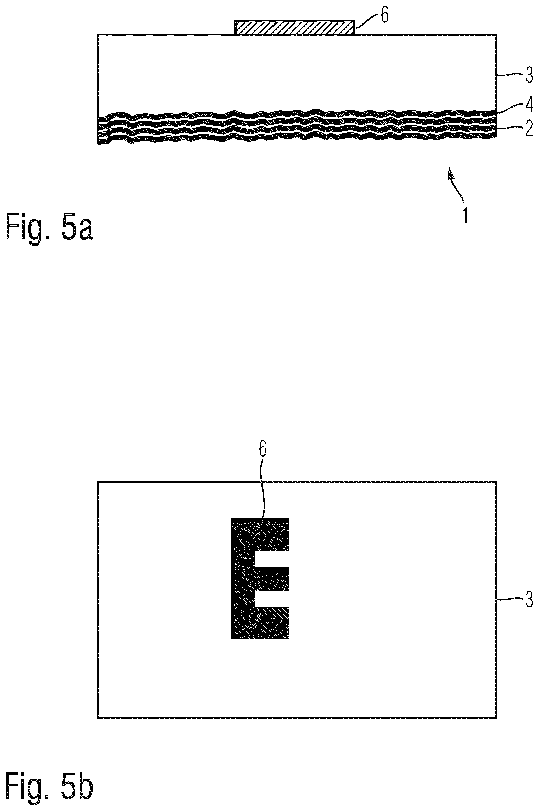

Die in den Fig. 5a und 5b gezeigte fünfte Ausführungsform der erfindungsgemäßen Verglasungseinheit weist eine dreidimensionale photonische Struktur 2, eine strukturierte Oberfläche 4 und ein Glas 3 auf. Auf der Oberfläche des Glases 3, befindet sich ein gestalterisches Element 6.

Dieses kann im einfachsten Fall mit einer Klebefolie erzeugt werden. In der Fig. 5a ist dies im Querschnitt dargestellt, und in der Fig. 5b als Draufsicht, in der das gestalterische Element in Form eines Buchstabens zu Zwecken der Illustration veranschaulicht ist.

Vorteilhaft ist jedoch, dass die Verglasungseinheit zur Erzeugung eines gestalterischen Elements erste Teilflächen aufweist, welche eine erste photonische Struktur aufweisen und zweite Teilflächen aufweist, welche eine zweite photonische Struktur oder keine photonische Struktur aufweisen. Wenn Teilflächen der Verglasungseinheit keine photonische Struktur aufweisen, erscheinen diese schwarz. Wenn ausgewählte Teilflächen der Verglasungseinheit eine andere photonische Struktur aufweisen als andere Teilflächen, so können diese in einer anderen Farbe erscheinen, wenn sich die Schichtdicken und/oder das Material der Einzelschichten und/oder oder die Anzahl der Einzelschichten unterscheiden. In anderen Ausführungsformen der Erfindung können Teilflächen mit dem identischen Bragg-Filter versehen sein, aber eine geringere Rauheit bzw. eine andere Oberflächenstrukturierung aufweisen. Hierdurch kann sich eine größere Winkelabhängigkeit des Farbeindruckes einstellen. Durch die Aufteilung in erste und zweite Teilflächen können Muster, Logos oder andere gestalterische Elemente auf der Verglasungseinheit ausgeführt werden. Gleichzeitig bleibt die hohe Transmission als wesentlicher Vorteil der Erfindung über die gesamte Fläche erhalten.

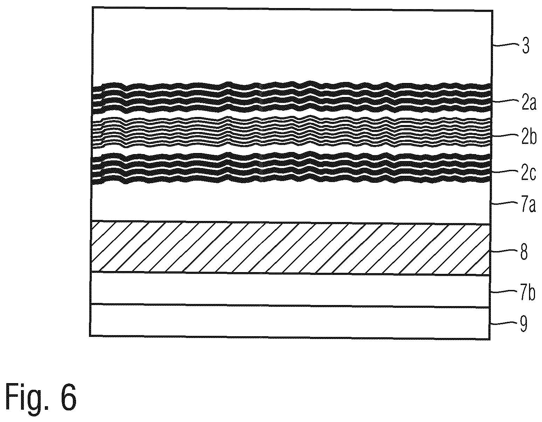

Figur 6 zeigt eine sechste Ausführungsform der Erfindung. In dieser wird gezeigt, wie eine erfindungsgemäße Verglasungseinheit 1 in ein Solarmodul eingebaut ist. Dabei weist das Solarmodul die Verglasungseinheit 1 als Deckglas auf.

Die erfindungsgemäße Verglasungseinheit mit dem Glas 3 und der photonischen Struktur 2 befindet sich auf einer ersten Einbettungsfolie 7a, die beispielsweise aus Ethylenvinylacetat oder Silikon hergestellt ist. Weiterhin enthält das Solarmodul eine zweite Einbettungsfolie 7b. Die Einbettungsfolien 7a, 7b schließen zumindest eine photovoltaische Zelle 8 ein. Dabei kann es sich um eine an sich bekannte photovoltaische Zelle handeln. Die Erfindung lehrt nicht die Verwendung einer bestimmten Zelle als Lösungsprinzip. Schließlich weist das Solarmodul eine übliche Rückseitenfolie 9 auf. Solche Solarmodule können für die gebäudeintegrierte Photovoltaik verwendet werden. Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal vorhanden ist. Dies schließt die Anwesenheit weiterer Merkmale nicht aus. Sofern die vorstehende Beschreibung "erste" und "zweite" Ausführungsformen definiert, so dient diese Bezeichnung der Unterscheidung zweier gleichartiger Ausführungsformen, ohne eine Rangfolge festzulegen.

**Patentansprüche**

1. Verglasungseinheit (1) zur ästhetischen Gestaltung, die mindestens ein Polymer (3) enthält, wobei das Polymer (3) eine erste strukturierte Oberfläche (4) aufweist, auf welche eine photonische Struktur (2) aufgebracht ist, welche dazu eingerichtet ist, ein erstes Teilspektrum eintreffender elektromagnetischer Strahlung zu reflektieren und ein zweites Teilspektrum eintreffender elektromagnetischer Strahlung zu transmittieren, **dadurch gekennzeichnet, dass** der reflektierte Anteil einer höheren Harmonischen entspricht und im sichtbaren Spektralbereich liegt.

2. Verglasungseinheit (1) nach Anspruch 1, **dadurch gekennzeichnet, dass** der mittlere Brechungsindex der photonischen Struktur (2) größer als etwa 1,6 oder größer als etwa 1,8 oder größer als etwa 1,95 ist, jeweils bestimmt bei einer Wellenlänge von 550 nm.

3. Verglasungseinheit (1) nach einem der Ansprüche 1 oder 2, **dadurch gekennzeichnet, dass** die photonische Struktur (2) einen Bragg-Filter enthält oder daraus besteht.

4. Verglasungseinheit (1) nach einem der Ansprüche 1 bis 3, **dadurch gekennzeichnet, dass** die photonische Struktur (2) erste Schichten aufweist, welche ein erstes Material enthalten, welches einen ersten Brechungsindex aufweist und die photonische Struktur (2) zweite Schichten aufweist, welche ein zweites Material enthalten, welches einen zweiten Brechungsindex aufweist, wobei der erste Brechungsindex zwischen etwa 1,5 und etwa 2,2 beträgt und der zweite Brechungsindex zwischen etwa 1,8 und etwa 2,5 beträgt.

5. Verglasungseinheit (1) nach einem der Ansprüche 1 bis 4, **dadurch gekennzeichnet, dass** die photonische Struktur (2) einen der folgenden Schichtaufbauten aufweist:

   - $Si_3N_4$ in einer Dicke von 140 nm, $TiO_2$ in einer Dicke von 170 nm, $Si_3N_4$ in einer Dicke von 200 nm, $TiO_2$ in einer Dicke von 170 nm und $Si_3N_4$ in einer Dicke von 140 nm, oder
   - $Si_3N_4$ in einer Dicke von 165 nm, $TiO_2$ in einer Dicke von 190 nm, $Si_3N_4$ in einer Dicke von 240 nm, $TiO_2$ in einer Dicke von 190 nm und $Si_3N_4$ in einer Dicke von 165 nm, oder
   - $Si_3N_4$ in einer Dicke von 120 nm, $TiO_2$ in einer Dicke von 140 nm, $Si_3N_4$ in einer Dicke von 170 nm, $TiO_2$ in einer Dicke von 140 nm und $Si_3N_4$ in einer Dicke von 120 nm, oder
   - $Si_3N_4$ in einer Dicke von 140 nm, $TiO_2$ in einer Dicke von 170 nm und $Si_3N_4$ in einer Dicke von 140 nm, oder
   - $Si_3N_4$ in einer Dicke von 165 nm, $TiO_2$ in einer Dicke von 190 nm und $Si_3N_4$ in einer Dicke von 165 nm, oder
   - $Si_3N_4$ in einer Dicke von 120 nm, $TiO_2$ in einer Dicke von 140 nm und $Si_3N_4$ in einer Dicke von 120 nm.

6. Verglasungseinheit (1) nach Anspruch 5, weiterhin enthaltend eine $SiO_2$-Schicht mit einer Dicke von etwa 100 nm bis etwa 230 nm oder von etwa 3 nm bis etwa 100 nm als den Schichtaufbau abschließende Deckschicht.

7. Verglasungseinheit (1) nach einem der Ansprüche 1 bis 6, **dadurch gekennzeichnet, dass** die Verglasungseinheit (1) mehrere photonische Strukturen (2a, 2b, 2c) aufweist, welche jeweils ein unterschiedliches erstes Teilspektrum reflektieren.

8. Verglasungseinheit (1) nach einem der Ansprüche 1 bis 7, **dadurch gekennzeichnet, dass** das Polymer (3) eine zweite strukturierte Oberfläche (5) aufweist, die sich gegenüber der ersten strukturierten Oberfläche (4) des Polymers (3) befindet oder
dass das Polymer (3) eine zweite strukturierte Oberfläche (5) aufweist, die sich gegenüber der ersten strukturierten Oberfläche (4) des Polymers (3) befindet und auf der zweiten strukturierten Oberfläche (5) zumindest eine zweite photonische Struktur angeordnet ist.

**9.** Verglasungseinheit (1) nach einem der Ansprüche 1 bis 8, **dadurch gekennzeichnet, dass** diese erste Flächenbereiche aufweist, welche eine erste photonische Struktur (2) aufweisen und zweite Flächenbereiche aufweist, welche eine zweite photonische Struktur oder keine photonische Struktur aufweisen.

**10.** Verfahren zur Herstellung einer Verglasungseinheit (1) zur ästhetischen Gestaltung, die mindestens eine photonische Struktur (2) und ein Polymer (3) umfasst, **gekennzeichnet durch** folgende Schritte: Bereitstellen eines Polymers (3),

Herstellen einer ersten strukturierten Oberfläche (4) auf dem Polymer (3) und
Aufbringen der photonischen Struktur (2) auf der ersten strukturierten Oberfläche (4), so dass diese dazu eingerichtet ist, ein erstes Teilspektrum eintreffender elektromagnetischer Strahlung zu reflektieren und ein zweites Teilspektrum eintreffender elektromagnetischer Strahlung zu transmittieren, **dadurch gekennzeichnet, dass** der reflektierte Anteil einer höheren Harmonischen entspricht und im sichtbaren Spektralbereich liegt.

**11.** Verfahren nach Anspruch 10, **dadurch gekennzeichnet, dass** das Aufbringen der photonischen Struktur (2) auf der ersten strukturierten Oberfläche (4) des Polymers (3) durch Sputtern erfolgt und/oder
dass die Herstellung der ersten strukturierten Oberfläche (4) durch Sandstrahlen, Ätzen, Prägen, Gießen oder Walzen erfolgt.

**12.** Verfahren nach einem der Ansprüche 10 bis 11, **dadurch gekennzeichnet, dass** auf der ersten strukturierten Oberfläche (4) vor dem Aufbringen der photonischen Struktur (2) eine Maske erzeugt wird, welche nach dem Aufbringen der photonischen Struktur (2) entfernt wird.

**13.** Verfahren nach Anspruch 12, **dadurch gekennzeichnet, dass** das Erzeugen der Maske durch Drucken erfolgt.

**14.** Solarmodul, enthaltend zumindest eine Verglasungseinheit (1) nach einem der Ansprüche 1 bis 9, zumindest einen ersten Einbettungsfilm (7a), zumindest eine Solarzelle (8), zumindest einen zweiten Einbettungsfilm (7b) und zumindest eine Rückseitenfolie (9).

**15.** Thermischer Solarkollektor mit einer Verglasungseinheit nach einem der Ansprüche 1 bis 9.

**Claims**

**1.** Glazing unit (1) for an esthetically pleasing effect, comprising at least one polymer (3), the polymer (3) having a first structured surface (4) to which a photonic structure (2) is applied which is configured to reflect a first partial spectrum of incident electromagnetic radiation and to transmit a second partial spectrum of incident electromagnetic radiation, **characterized in that** the reflected proportion corresponds to a higher harmonic and is in the visible spectral range.

**2.** Glazing unit (1) according to claim 1, wherein the mean refractive index of the photonic structure (2) is greater than about 1.6 or greater than about 1.8 or greater than about 1.95, in each case determined at a wavelength of 550 nm.

**3.** Glazing unit (1) according to any of claims 1 or 2, wherein the photonic structure (2) contains or consists of a Bragg filter.

**4.** Glazing unit (1) according to any of claims 1 to 3, wherein the photonic structure (2) includes first layers containing a first material having a first refractive index and the photonic structure (2) includes second layers containing a second material having a second refractive index, the first refractive index being between about 1.5 and about 2.2 and the second refractive index being between about 1.8 and about 2.5.

**5.** Glazing unit (1) according to any of claims 1 to 4, wherein the photonic structure (2) has one of the following layer structures:

- $Si_3N_4$ in a thickness of 140 nm, $TiO_2$ in a thickness of 170 nm, $Si_3N_4$ in a thickness of 200 nm, $TiO_2$ in a thickness of 170 nm and $Si_3N_4$ in a thickness of 140 nm, or
- $Si_3N_4$ in a thickness of 165 nm, $TiO_2$ in a thickness of 190 nm, $Si_3N_4$ in a thickness of 240 nm, $TiO_2$ in a thickness of 190 nm and $Si_3N_4$ in a thickness of 165 nm, or
- $Si_3N_4$ in a thickness of 120 nm, $TiO_2$ in a thickness of 140 nm, $Si_3N_4$ in a thickness of 170 nm, $TiO_2$ in a thickness

of 140 nm and $Si_3N_4$ in a thickness of 120 nm, or
- $Si_3N_4$ in a thickness of 140 nm, $TiO_2$ in a thickness of 170 nm and $Si_3N_4$ in a thickness of 140 nm, or
- $Si_3N_4$ in a thickness of 165 nm, $TiO_2$ in a thickness of 190 nm and $Si_3N_4$ in a thickness of 165 nm, or
- $Si_3N_4$ in a thickness of 120 nm, $TiO_2$ in a thickness of 140 nm and $Si_3N_4$ in a thickness of 120 nm.

6. Glazing unit (1) according to claim 5, further containing an $SiO_2$ layer having a thickness of about 100 nm to about 230 nm or of about 3 nm to about 100 nm as a cover layer completing the layer structure.

7. Glazing unit (1) according to any of claims 1 to 6, wherein the glazing unit (1) includes a plurality of photonic structures (2a, 2b, 2c) each reflecting a different first partial spectrum.

8. Glazing unit (1) according to any of claims 1 to 7, wherein the polymer (3) includes a second structured surface (5) disposed opposite to the first structured surface (4) of the polymer (3) or the polymer (3) includes a second structured surface (5) which is disposed opposite to the first structured surface (4) of the polymer (3), and at least one second photonic structure is arranged on the second structured surface (5).

9. Glazing unit (1) according to any of claims 1 to 8, wherein it comprises first surface regions having a first photonic structure (2) and second surface regions having a second photonic structure or no photonic structure.

10. Method for producing a glazing unit (1) for the esthetically pleasing effect, comprising at least one photonic structure (2) and a polymer (3), **characterized by** the following steps:

   providing a polymer (3),
   producing a first structured surface (4) on the polymer (3) and applying the photonic structure (2) to the first structured surface (4) so that it is configured to reflect a first partial spectrum of incident electromagnetic radiation and to transmit a second partial spectrum of incident electromagnetic radiation, **characterized in that** the reflected proportion corresponds to a higher harmonic and is in the visible spectral range.

11. Method according to claim 10, wherein the photonic structure (2) is applied to the first structured surface (4) of the polymer (3) by sputtering and/or
   the first structured surface (4) is produced by sandblasting, etching, embossing, casting or rolling.

12. Method according to any of claims 10 to 11, wherein a mask is produced on the first structured surface (4) before the application of the photonic structure (2), which mask is removed after the application of the photonic structure (2).

13. Method according to claim 12, wherein the mask is produced by printing.

14. Solar module containing at least one glazing unit (1) according to any of claims 1 to 9, at least one first embedding film (7a), at least one solar cell (8), at least one second embedding film (7b) and at least one backside film (9).

15. Thermal solar collector with a glazing unit according to any of claims 1 to 9.

**Revendications**

1. Unité de vitrage (1) pour la conception esthétique, qui contient au moins un polymère (3), le polymère (3) présentant une première surface structurée (4) sur laquelle est appliquée une structure photonique (2) qui est adaptée pour réfléchir un premier spectre partiel de rayonnement électromagnétique incident et pour transmettre un deuxième spectre partiel de rayonnement électromagnétique incident,
   **caractérisée en ce que**
   la partie réfléchie correspond à une harmonique supérieure et est située dans le domaine spectral visible.

2. Unité de vitrage (1) selon la revendication 1,
   dans laquelle l'indice de réfraction moyen de la structure photonique (2) est supérieur à environ 1,6 ou supérieur à environ 1,8 ou supérieur à environ 1,95, ces valeurs étant toutes déterminées à une longueur d'onde de 550 nm.

3. Unité de vitrage (1) selon l'une des revendications 1 ou 2,
   dans laquelle la structure photonique (2) contient ou est constituée d'un filtre de Bragg.

4. Unité de vitrage (1) selon l'une des revendications 1 à 3, dans laquelle la structure photonique (2) comprend des premières couches contenant un premier matériau ayant un premier indice de réfraction, et la structure photonique (2) comprend des deuxièmes couches contenant un deuxième matériau ayant un deuxième indice de réfraction, le premier indice de réfraction étant compris entre environ 1,5 et environ 2,2 et le deuxième indice de réfraction étant compris entre environ 1,8 et environ 2,5.

5. Unité de vitrage (1) selon l'une des revendications 1 à 4, dans laquelle la structure photonique (2) présente l'une des structures en couches suivantes :

- $Si_3N_4$ d'une épaisseur de 140 nm, $TiO_2$ d'une épaisseur de 170 nm, $Si_3N_4$ d'une épaisseur de 200 nm, $TiO_2$ d'une épaisseur de 170 nm et $Si_3N_4$ d'une épaisseur de 140 nm, ou
- $Si_3N_4$ d'une épaisseur de 165 nm, $TiO_2$ d'une épaisseur de 190 nm, $Si_3N_4$ d'une épaisseur de 240 nm, $TiO_2$ d'une épaisseur de 190 nm et $Si_3N_4$ d'une épaisseur de 165 nm, ou
- $Si_3N_4$ d'une épaisseur de 120 nm, $TiO_2$ d'une épaisseur de 140 nm, $Si_3N_4$ d'une épaisseur de 170 nm, $TiO_2$ d'une épaisseur de 140 nm et $Si_3N_4$ d'une épaisseur de 120 nm, ou
- $Si_3N_4$ d'une épaisseur de 140 nm, $TiO_2$ d'une épaisseur de 170 nm et $Si_3N_4$ d'une épaisseur de 140 nm, ou
- $Si_3N_4$ d'une épaisseur de 165 nm, $TiO_2$ d'une épaisseur de 190 nm et $Si_3N_4$ d'une épaisseur de 165 nm, ou
- $Si_3N_4$ d'une épaisseur de 120 nm, $TiO_2$ d'une épaisseur de 140 nm et $Si_3N_4$ d'une épaisseur de 120 nm.

6. Unité de vitrage (1) selon la revendication 5, comprenant en outre une couche de $SiO_2$ d'une épaisseur d'environ 100 nm à environ 230 nm ou d'environ 3 nm à environ 100 nm comme couche de couverture terminant la structure en couches.

7. Unité de vitrage (1) selon l'une des revendications 1 à 6, dans laquelle l'unité de vitrage (1) présente plusieurs structures photoniques (2a, 2b, 2c) qui réfléchissent chacune un premier spectre partiel différent.

8. Unité de vitrage (1) selon l'une des revendications 1 à 7,

dans laquelle le polymère (3) présente une deuxième surface structurée (5) qui se trouve à l'opposé de la première surface structurée (4) du polymère (3), ou
le polymère (3) présente une deuxième surface structurée (5) qui se trouve à l'opposé de la première surface structurée (4) du polymère (3), et
au moins une deuxième structure photonique est disposée sur la deuxième surface structurée (5).

9. Unité de vitrage (1) selon l'une des revendications 1 à 8, comprenant des premières zones de surface qui présentent une première structure photonique (2), et comprenant des deuxièmes zones de surface qui présentent une deuxième structure photonique ou ne présentent aucune structure photonique.

10. Procédé de fabrication d'une unité de vitrage (1) pour la conception esthétique, comprenant au moins une structure photonique (2) et un polymère (3), **caractérisé par** les étapes suivantes consistant à :

fournir un polymère (3),
réaliser une première surface structurée (4) sur le polymère (3), et
appliquer la structure photonique (2) sur la première surface structurée (4), de sorte que celle-ci est adaptée pour réfléchir un premier spectre partiel de rayonnement électromagnétique incident et pour transmettre un deuxième spectre partiel de rayonnement électromagnétique incident,
**caractérisé en ce que**
la partie réfléchie correspond à une harmonique supérieure et est située dans le domaine spectral visible.

11. Procédé selon la revendication 10,

dans lequel l'application de la structure photonique (2) sur la première surface structurée (4) du polymère (3) s'effectue par pulvérisation cathodique, et/ou
la réalisation de la première surface structurée (4) s'effectue par sablage, gravure, estampage, coulage ou laminage.

**12.** Procédé selon l'une des revendications 10 à 11,
dans lequel un masque est généré sur la première surface structurée (4) avant l'application de la structure photonique (2), masque qui est retiré après l'application de la structure photonique (2).

**13.** Procédé selon la revendication 12,
dans lequel la génération du masque s'effectue par impression.

**14.** Module solaire comprenant au moins une unité de vitrage (1) selon l'une des revendications 1 à 9, au moins un premier film d'enrobage (7a), au moins une cellule solaire (8), au moins un deuxième film d'enrobage (7b) et au moins un film de face arrière (9).

**15.** Collecteur solaire thermique comprenant une unité de vitrage selon l'une des revendications 1 à 9.

Fig. 1

3
4
2

1

Fig. 2

3
4
2a
2b
2c

1

Fig. 3

Fig. 4

Fig. 5a

Fig. 5b

Fig. 6

**EP 3 757 480 B2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150249424 A1
- WO 2015155357 A